(19) **Europäisches Patentamt / European Patent Office / Office européen des brevets**

(11) **EP 1 693 968 B1**

(12) **EUROPEAN PATENT SPECIFICATION**

(45) Date of publication and mention
of the grant of the patent:
**04.06.2008 Bulletin 2008/23**

(51) Int Cl.:
***H03M 13/11*** *(2006.01)*

(21) Application number: **05251010.4**

(22) Date of filing: **22.02.2005**

(54) **Low-density parity-check (LDPC) coding method and apparatus**

Vorgehensweise und Apparat zur Encodierung von Low-Density Parity-Check (LDPC) Codes

Méthod et appareil pour le codage de codes LDPC

(84) Designated Contracting States:
**DE FR GB**

(43) Date of publication of application:
**23.08.2006 Bulletin 2006/34**

(73) Proprietor: **Lucent Technologies Inc.**
**Murray Hill, New Jersey 07974-0636 (US)**

(72) Inventors:
- **Ballester, Raul Benet**
  **Premia de Mar**
  **08330 (ES)**
- **Van Wijngaard, Adriaan de Lind**
  **New Providence**
  **Union**
  **NJ 07974 (US)**
- **Dohman, Ralf**
  **VS-Villingen**
  **78050 (DE)**
- **Richardson, Thomas**
  **South Orange**
  **Essex**
  **NJ 07079 (US)**
- **Urbanke, Rudiger**
  **Lausanne**
  **CH 1015 (CH)**

(74) Representative: **Sarup, David Alexander et al**
**Alcatel-Lucent Telecom Limited**
**Unit 18, Core 3,**
**Workzone**
**Innova Business Park**
**Electric Avenue**
**Enfield, EN3 7XU (GB)**

- **SONG H. AND KUMAR V.: "Low-density parity-check codes for partial response channels" IEEE SIGNAL PROCESSING MAGAZINE, vol. 21, no. 1, January 2004 (2004-01), pages 56-66, XP002325692**
- **MOURA J., LU J AND ZHANG H.: "Structured low-density parity-check codes" IEEE SIGNAL PROCESSING MAGAZINE, vol. 21, no. 1, January 2004 (2004-01), pages 42-55, XP002325693**
- **RICHARDSON T J ET AL: "Efficient encoding of low-density parity-check codes" IEEE TRANSACTIONS ON INFORMATION THEORY, IEEE INC. NEW YORK, US, vol. 47, no. 2, February 2001 (2001-02), pages 638-656, XP002965294 ISSN: 0018-9448**
- **VASIC B.: "High-rate low-density parity check codes based on anti-pasch affine geometries" PROC., IEEE INTERNATIONAL CONFERENCE ON COMMUNICATIONS, ICC 2002, NEW YORK, NY, vol. VOL. 1 OF 5, 28 April 2002 (2002-04-28) - 2 May 2002 (2002-05-02), pages 1332-1336, XP010589705 ISBN: 0-7803-7400-2**
- **VASIC B. ET AL: "Combinatorial constructions of low-density parity-check codes for iterative decoding" IEEE TRANSACTIONS ON INFORMATION THEORY, vol. 50, no. 6, June 2004 (2004-06), pages 1156-1176, XP002325694 ISSN: 0018-9448**
- **VASIC B. ET AL: "High-rate girth-eight low-density parity-check codes on rectangular integer lattices" IEEE TRANSACTIONS ON COMMUNICATIONS, vol. 52, no. 8, August 2004 (2004-08), pages 1248-1252, XP002325695 ISSN: 0090-6778**

(56) References cited:
**US-A1- 2004 093 549**

EP 1 693 968 B1

- HONG WEN ET AL: "A new family of irregular LDPC Codes" PROC., IEEE 6TH SYMPOSIUM ON CIRCUITS AND SYSTEMS, SHANGHAI, CHINA, vol. 1, 31 May 2004 (2004-05-31) - 2 June 2004 (2004-06-02), pages 285-288, XP010716074 ISBN: 0-7803-7938-1

- YU YI ET AL: "The semi-algebra low-density parity-check codes" PROC., IEEE INTERNATIONAL CONFERENCE ON COMMUNICATIONS, PARIS, FRANCE, vol. 1, 20 - 24 June 2004, pages 440-443, XP010710384 ISBN: 0-7803-8533-0

## Description

### Field of the Invention

This invention relates to coding methods for low-density parity check (LDPC) codes.

### Art Background

Practically all communication and storage systems use error control coding methods to detect or correct errors that resulted from transmission, detection or processing. In many systems it is desirable to add redundancy to the original message to aid the recovery of transmitted information from a signal received in error. Various methods are in use to date to encode signals with redundant information included in the encoded bit stream.

Low-Density Parity-Check (LDPC) codes provide one basis, among others, for adding redundancy to transmitted information. The codes are typically defined by a set of linear constraints that require certain designated groups of bits of every codeword to add up (in modulo-2 arithmetic over Galois Field $\mathbb{F}_2$) to a specified binary value such as 0. In that regard, a sum of 0 would be referred to as an even parity sum and a sum of 1 would be referred to as an odd parity sum. An LDPC code of length $n$ can thus be specified as the set of all vectors $c = c_1 c_2 \ldots c_n, \in \mathbb{F}_2^n$ that fulfill a linear algebraic equation $Hc^{tr} = 0$ that represents a set of parity-check equations. Here, $H \in M_{n,r}(\mathbb{F}_2)$ is an $n \times r$ binary matrix defined over $\mathbb{F}_2$) with a low density of ones and 0 denotes the all-zero vector of length $r$.

One recently proposed class of LDPC codes defines the constraints by arranging $k_c$ information bits and $r_c$ check bits in a $p \times p$ matrix $C$, in which $p$ is a prime number. The check bits are chosen such that certain parity-check constraints are satisfied. The code length $n$, being equal to $k_c + r_c$, is at most $p^2$. If the code length is less than $p^2$, unused elements in the $p \times p$ matrix are typically set to 0.

The coefficients of the matrix $C$ form a two-dimensional $p \times p$ grid. The designated groups of bits that underlie parity-check constraints are specified by straight lines through the $p \times p$ grid that specify one bit in each row and column of the array. The parity sums are formed over the groups of bits that are specified by the constructed lines. Bits at specified positions in the array are reserved as check bits. The rest of the bits of the array are the information bits, also referred to as "systematic" bits. These are, if they are used at all, assigned the bit values of the information sequence that is to be transmitted. Using the systematic bits as input, a computation is performed to determine the values of the check bits that will satisfy the constraints.

The computation of the check bits is typically carried out by a digital data processor or an Application-Specific Integrated Circuit (ASIC). Because both hardware and computational time are costly, it is desirable to compute the check bits by a method that is economical in its use of computational resources. This is especially important in view of the size of the computational problem that is presented. The length of a codeword is typically in the range from several thousand to a hundred thousand or more bits, and there may be thousands or more of constraints.

Yu Yi et al. published in their paper "The semi-algebra low-density parity-check codes", Proc., IEEE Int. Conf. on Comm., Paris, France, 20-24 June 2004, pp.440-442, an efficient encoding method for semi-algebra LDPC codes having a dual-diagonal sub-matrix in the parity check matrix.

### Summary of the Invention

We have discovered an efficient method for computing the values of the check bits given the values of the systematic bits, provided that an LDPC code adheres to a certain structure described here.

In a broad aspect, our invention involves a method for encoding information by computing a codeword having systematic bits and check bits. A portion, for example the first $d$ rows, of a $p \times p$ matrix $C = [c_{i,j}] \in M_{p,p}(\mathbb{F}_2)$) are reserved for the check bits and are initially set to 0. The values of the systematic bits, that are provided by a source for transmission, are assigned consecutively to another portion, for example to rows $d + 1$ up to row $p$. Unused bits are set to zero. Let vector $c_i = c_{i,1} c_{i,2} \cdots c_{i,p}$ now denote the $i$-th row of the $p \times p$ matrix $C$. A word $c = c_1 c_2 \cdots c_p$ is a codeword if $Hc^{tr} = 0$, where $c^{tr}$ denotes the transpose of $c$. The first $d$ rows, for example, contain the check bits, which are initially set to 0. Rows $c_{d+1} \cdots c_p$, for example, hold the systematic information-carrying bits, some of which may be unused and regarded as being set to 0. From these bits, parity sums are computed. Values for the check bits must be determined so as to satisfy the parity sums according to the equation $H_1 x^{tr} = y^{tr}$, wherein the vector $x \in \mathbb{F}_2^{\gamma}$ represents the check bits, the vector $y \in \mathbb{F}_2^{\gamma}$ represents the computed parity sums, and the matrix $H_1 \in M_{r,r}(\mathbb{F}_2)$ is a binary sub-matrix of $H$ that represents a set of linear constraints on the set of check bits. The constraint equation $\boldsymbol{H_1} x^{tr} = \boldsymbol{y}^{tr}$ is solved to obtain the values for the check bits.

To solve the constraint equation, the parity sums are arranged into d vectors $\boldsymbol{y} = \boldsymbol{y_1} \dots \boldsymbol{y_d}$, wherein $d$ is the number of linear constraints imposed on each check bit and $\boldsymbol{y_i} = y_{(i-1)p+1} y_{(i-1)p+2} \cdots y_{ip}$. Then, an intermediate set of vectors $\boldsymbol{z_1}, \boldsymbol{z_2}, \dots, \boldsymbol{z_d}$ are computed from the vectors $y_i$ using a recursive relationship among the vectors $\boldsymbol{z_i}$. Then, the values for the check bits are computed as a set of vectors $\boldsymbol{x_1}, \boldsymbol{x_2}, \dots, \boldsymbol{x_d}$ by a circuit having multiple levels, in which at least one sub-circuit at each level obtains two vector inputs, sums one of the vector inputs with a shifted version of the other vector input, and passes the result to the next level or outputs it as one of the vectors $\boldsymbol{x_i}$.

The check bits that have been obtained are appended to the systematic bits to form the complete codeword.

In a second aspect, the invention involves an apparatus such as a digital data processor or ASIC configured to carry out the method described above.

## Brief Description of the Drawings

FIG. 1 is a graphical representation used to describe the construction of an LDPC code of length 49.

FIG. 2 is a schematic diagram of a codeword which contains check bits and systematic bits, arranged as vectors or rows of the codeword matrix.

FIG. 3 is a high-level flow chart of a method for obtaining check bits according to one aspect of the present invention.

FIG. 4 is a detail of a parity check computation box of FIG. 3.

FIG. 5 is a detail of the Stage-1 Processing box of FIG. 3.

FIG. 6 is a detail of the Stage-2 Processing box of FIG. 3.

FIG. 7 is a high-level flow chart of SOLVER, which comprises two permutations and a universal SOLVER module. SOLVER is an algorithm for inverting a matrix that is the sum of two cyclic shift matrices.

FIG. 8 is a schematic diagram of a circuit useful for an implementation of a submodule of SOLVER, which takes advantage of recursive relationships among certain variables.

## Detailed Description

The method is conveniently explained by specifying one class of codes and providing as an example an illustrative code of short length. The example is not limiting. In general, the method can be used for a much wider variety of codes.

The class of codes that is considered is specified by an $n \times r$ parity check matrix $H \in M_{n,r}(\mathbb{F}_2)$. Before we specify the matrix $H$, we arrange the $n$ bits of the codewords in a $p \times p$ matrix $C = [c_{i,j}] \in M_{p,p}(\mathbb{F}_2)$, where $n \leq p^2$, and $p$ is prime. Each row may be regarded as a binary vector $c_i = c_{i,1} c_{i,2} \cdots c_{i,p}$, where $1 \leq i \leq p$. For convenience, we assume from now on that $n = p^2$. Shorter codes are generated by setting the unused positions in the matrix to 0 and by not transmitting these bits.

The grouping of the parity-check bits is best explained for a small example code of length $n = p^2 = 49$, that has the property that each bit of the codeword must satisfy $d = 4$ parity conditions, which in this example are linear constraints.

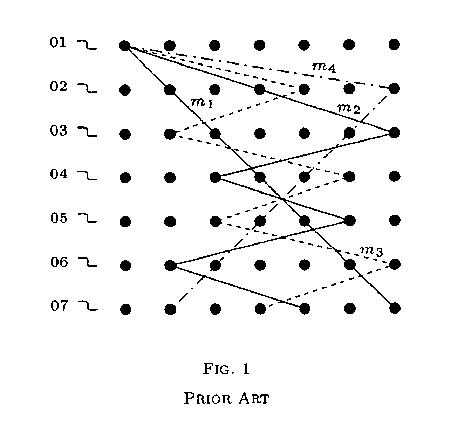

Each of the linear constraints involves $p = 7$ bits of the codeword. The matrix indices of $C = [c_{i,j}] \in M_{7,7}(\mathbb{F}_2)$ in this example may be thought of as a $7 \times 7$ grid, as seen in FIG. 1. In the figure, the rows are identified by the respective reference numerals 01-07. Each row may be regarded as a binary vector $\boldsymbol{c_i} = \boldsymbol{c_{i,1}} \boldsymbol{c_{i,2}} \cdots \boldsymbol{c_{i,p}}$, where $1 \leq i \leq p$. Thus, row 01 will also be referred to as the vector $\boldsymbol{c_1}$, row 02 as $\boldsymbol{c_2}$, row 03 as $\boldsymbol{c_3}$, row 04 as $\boldsymbol{c_4}$, row 05 as $\boldsymbol{c_5}$, row 06 as $\boldsymbol{c_6}$ and row 07 as $\boldsymbol{c_7}$.

Each of the linear constraints is defined by a straight line of integer slope $m_1$, $m_2$, $m_3$ and $m_4$, which specifies precisely one bit in each of rows 01-07, together with a requirement that the seven specified bits must add up to a specified modulo-2 number, such as 0. Each such line may be regarded as originating at a respective bit of row 01. Thus, the total number of lines and of linear constraints is 28, i.e., the product of the number of slopes times the number of bits of row 01.

For purposes of illustration, FIG. 1 shows the four lines that pass through the first bits of row 01, respectively labeled $m_1$, $m_2$, $m_3$ and $m_4$. It will be seen on examining the figure that due to a periodic boundary condition, the lines labeled $m_2$, $m_3$ and $m_4$ are folded.

To better understand how the periodic boundary condition causes folding, associate with every matrix index $(a + 1, b + 1)$ a grid point $(a, b)$, where $a \in \mathbb{Z}_p$, $b \in \mathbb{Z}_p$, and $\mathbb{Z}_p := \{0,1, \cdots , p - 1\}$, the set of integers modulo $p$.

One key observation helpful for understanding the construction of this code is that parity-check constraints can be specified by elements of a line in the $p \times p$ grid. Each line can be identified by one coordinate and its slope $m$, e.g., the column index of the bit located where the line intersects the first row of the codeword. If $(a + 1, b + 1)$ are the row and column indices of a point on a line, the entire non-horizontal line in a $p \times p$ grid will be generated by the expression $(a, b) + t(1, m) \in \mathbb{Z}_p^2$, where $t \in \mathbb{Z}_p$. In this way, p bits of the codeword are grouped. The code requires that the parity-check sum of this grouping of bits is 0 modulo 2.

Another key observation is that even-parity sums can be assured if each line is divided into the portion which specifies systematic bits and the portion which specifies check bits. A condition sufficient to assure an even parity sum is that the partial sum due to systematic bits have the same parity as the partial sum due to check bits. The partial parity sums due to the systematic bits are readily obtained by known methods. These partial sums can then be used as input data for computing the desired values of the check bits. Accordingly, the description of our method which is set out below will be primarily directed to operations carried out on a sub-matrix consisting of the first d rows of the codeword and populated by the check bits. As noted, d is the number of non-zero slopes of the lines that define the linear constraints.

Still another key observation is that cyclic shift operators can be used to simplify the computation of parity sums. In this regard, reference is made to FIG. 1. where four lines with respective slopes $m_1$, $m_2$, $m_3$ and $m_4$ pass through the first element of the first row.

The set of constraints corresponding to the construction shown in FIG. 1 can be specified in matrix form by

$$H = \begin{bmatrix} I & S^{m_1} & S^{2m_1} & S^{3m_1} & S^{4m_1} & S^{5m_1} & S^{6m_1} \\ I & S^{m_2} & S^{2m_2} & S^{3m_2} & S^{4m_2} & S^{5m_2} & S^{6m_2} \\ I & S^{m_3} & S^{2m_3} & S^{3m_3} & S^{4m_3} & S^{5m_3} & S^{6m_3} \\ I & S^{m_4} & S^{2m_4} & S^{3m_4} & S^{4m_4} & S^{5m_4} & S^{6m_4} \end{bmatrix} . \qquad (1)$$

where $I \in M_{p,p}(\mathbb{F}_2)$ denotes the identity matrix, and $S \in M_{p,p}(\mathbb{F}_2)$ denotes the shift matrix, which is given by

$$S = \begin{bmatrix} 0 & 1 & 0 & 0 & 0 & 0 & 0 \\ 0 & 0 & 1 & 0 & 0 & 0 & 0 \\ 0 & 0 & 0 & 1 & 0 & 0 & 0 \\ 0 & 0 & 0 & 0 & 1 & 0 & 0 \\ 0 & 0 & 0 & 0 & 0 & 1 & 0 \\ 0 & 0 & 0 & 0 & 0 & 0 & 1 \\ 1 & 0 & 0 & 0 & 0 & 0 & 0 \end{bmatrix} . \qquad (2)$$

It can be easily verified that for a given vector $v = v_1 v_2 \cdots v_p \in \mathbb{F}_2^p$, $(Sv^{\text{tr}})^{\text{tr}} = v_2 v_3 \cdots v_p v_1$. Similarly, $(S^2 v^{\text{tr}})^{\text{tr}} = v_3 \cdots v_p v_1 v_2$. Generally, $S^m v^{\text{tr}}$ represents the transformation that causes a vector to undergo a cyclic shift of m positions. Note that $S^p = S^0 = I$.

It will be appreciated that the non-zero entries in the first row of $H$ correspond in sequential position to those bits of the codeword that enter into the parity sum defined by $m_1 = 1$ through the upper-left position in the grid shown in FIG. 1. The first p rows of $H$ correspond to all the parity check equations of slope $m_1$. In analogous fashion, each of the parity sums corresponding to the lines of slopes $m_2$, $m_3$, and $m_4$ can be computed as a sum of entries in a corresponding row of the matrix $H$.

In general, let the *matrix H* have $d$ rows and $p$ columns of submatrices, wherein the slopes $m_1$, ... , $m_d$ have $d$ distinct non-zero values and each given slope $m_i$ generates $p$ lines and thus $p$ parity sums. Matrix $H$ then takes the form

$$H = \begin{bmatrix} M_1 \\ M_2 \\ \vdots \\ M_d \end{bmatrix}, \qquad (3)$$

where $M_i \in M_{p,p2}$, defined by

$$M_i = \begin{bmatrix} S^0 S^{m_i} S^{2m_i} \cdots S^{(p-1)m_i} \end{bmatrix} \qquad (4)$$

and $S \in M_{p,p}$.

In the submatrix $M_i$, successive subvectors of length $p$ are advanced by $m_i$ positions because the corresponding lines have slope $m_i$. Each of the parity sums corresponding to the lines with slope $m_i$ can be computed as a sum of entries in a corresponding row, wherein $m_i$ designates the slope, and $S^{qm_i}$, where $q \in \mathbb{Z}_p$, is an operator that cyclically shifts each successive row $c_q$ by $m_i$ positions relative to the preceding row.

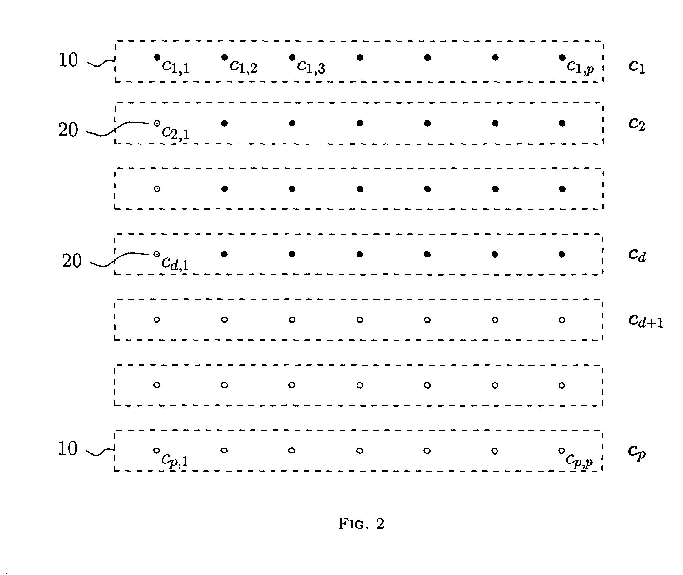

FIG. 2 shows a matrix $C = c_{i,j}$ corresponding to FIG. 1. Each of the rows has been represented simply as a rectangular bar 10 and is referred to by $c_1$ up to $c_p$. The check bits occupy the first four rows $c_1$ up to $c_d$, corresponding to $d = 4$ designated slopes $m_1$, ... , $m_4$. The initial bit from each row of check bits except the first row has been represented as a small open circle with a dot inside as designated by reference numeral 20. Mathematical theory has shown that of $dp$ possible check bits, $d - 1$ are redundant. Therefore, the three (i.e., one less than d) bit positions $c_{2,1}$, ... , $c_{d,1}$ may be reserved for further systematic bits. The other positions in the first four rows are occupied by the check bits, which are identified by filled black circles. The rows $c_{d+1}$ up to $c_p$ contain the systematic bits, identified by open circles.

To solve the ensemble of parity-check equations $Hc^{tr} = 0$, we have to compute the check bits $c_1 \cdots c_d$ given $p$ $(p - d)$ systematic bits $c_{d+1} \cdots c_p$. This is done by rewriting $Hc^{tr} = 0$ to

$$H_1 \begin{bmatrix} c_1 \cdots c_d \end{bmatrix}^{tr} + H_2 \begin{bmatrix} c_{d+1} \cdots c_p \end{bmatrix}^{tr} = 0 \qquad (5)$$

In the case of $p = 7$, as in FIG. 1, the sub-matrices $H_1$ and $H_2$ have the following form

$$H_1 = \begin{bmatrix} I & S^{m_1} & S^{2m_1} & S^{3m_1} \\ I & S^{m_2} & S^{2m_2} & S^{3m_2} \\ I & S^{m_3} & S^{2m_3} & S^{3m_3} \\ I & S^{m_4} & S^{2m_4} & S^{3m_4} \end{bmatrix}. \qquad (6)$$

and

$$H_2 = \begin{bmatrix} S^{4m_1} & S^{5m_1} & S^{6m_1} \\ S^{4m_2} & S^{5m_2} & S^{6m_2} \\ S^{4m_3} & S^{5m_3} & S^{6m_3} \\ S^{4m_4} & S^{5m_4} & S^{6m_4} \end{bmatrix} . \tag{7}$$

Collectively, the linear constraints are concisely stated by the expression $y^{tr} = H_1 x^{tr}$, wherein each row of $p \times p$ submatrices in $H_1$ corresponds to one of the slopes $m_1, \ldots , m_d$.

In the first step, we compute $y^{tr} = H_2 [c_{d+1} \cdots c_p]^{tr}$. This can be done in parallel on a row-by-row basis of p bits each. For each slope $m_i$, we have

$$y_i^{tr} = \begin{bmatrix} S^{(d+1)m_i} S^{(d+2)m_i} \cdots S^{(p-1)m_i} \end{bmatrix} [c_{d+1} \cdots c_p]^{tr} \tag{8}$$

In the example of FIG. 1, the constraint equation $H_1 x^{tr} = y^{tr}$ can be written in terms of column vectors and a fully elaborated matrix of shift operators as:

$$\begin{bmatrix} I & S^{m_1} & S^{2m_1} & S^{3m_1} \\ I & S^{m_2} & S^{2m_2} & S^{3m_2} \\ I & S^{m_3} & S^{2m_3} & S^{3m_3} \\ I & S^{m_4} & S^{2m_4} & S^{3m_4} \end{bmatrix} \begin{bmatrix} x_1^{tr} \\ x_2^{tr} \\ x_3^{tr} \\ x_4^{tr} \end{bmatrix} = \begin{bmatrix} y_1^{tr} \\ y_2^{tr} \\ y_3^{tr} \\ y_4^{tr} \end{bmatrix} \tag{9}$$

The object of our method is to bring about an effective inversion of $H_1$, so that, given the vector $y$ of parity sums, the vector $x$ of check bits can be determined.

The matrix $H_1$ in the example of FIG. 1 can be transformed by multiplication of $H_1$ by matrix $F^{(1)}$ of the form

$$F^{(1)} = \begin{bmatrix} I & S^{m_1} & 0 & 0 \\ 0 & I & S^{m_1} & 0 \\ 0 & 0 & I & S^{m_1} \\ 0 & 0 & 0 & I \end{bmatrix} . \tag{10}$$

As a result, we now obtain

$$H_1 F^{(1)} = \begin{bmatrix} I & 0 & 0 & 0 \\ I & (S^{m_1} + S^{m_2}) & S^{m_2}(S^{m_1} + S^{m_2}) & S^{2m_2}(S^{m_1} + S^{m_2}) \\ I & (S^{m_1} + S^{m_3}) & S^{m_3}(S^{m_1} + S^{m_3}) & S^{2m_3}(S^{m_1} + S^{m_3}) \\ I & (S^{m_1} + S^{m_4}) & S^{m_4}(S^{m_1} + S^{m_4}) & S^{2m_4}(S^{m_1} + S^{m_4}) \end{bmatrix} \tag{11}$$

This process can be repeated by multiplying the resulting matrix by

$$F^{(2)} = \begin{bmatrix} I & 0 & 0 & 0 \\ 0 & I & S^{m_2} & 0 \\ 0 & 0 & I & S^{m_2} \\ 0 & 0 & 0 & I \end{bmatrix} \tag{12}$$

and

$$F^{(3)} = \begin{bmatrix} I & 0 & 0 & 0 \\ 0 & I & 0 & 0 \\ 0 & 0 & I & S^{m_3} \\ 0 & 0 & 0 & I \end{bmatrix} \tag{13}$$

to obtain matrix $T = H_1 F$, where $F = F^{(1)}F^{(2)}F^{(3)}$, which is equal to

$$T = \begin{bmatrix} I & 0 & 0 & 0 \\ I & (S^{m_1} + S^{m_2}) & 0 & 0 \\ I & (S^{m_1} + S^{m_3}) & (S^{m_1} + S^{m_3})(S^{m_2} + S^{m_3}) & 0 \\ I & (S^{m_1} + S^{m_4}) & (S^{m_1} + S^{m_4})(S^{m_2} + S^{m_4}) & (S^{m_1} + S^{m_4})(S^{m_2} + S^{m_4})(S^{m_3} + S^{m_4}) \end{bmatrix}. \tag{14}$$

It will be appreciated that $T$ is a lower-triangular matrix of submatrices.

A key observation is that a pair of matrices $F$, $T$ are readily determined from $H_1$, such that $H_1 F = T$, and $T$ is a lower-triangular matrix of submatrices. An effective inversion of $H_1$ can be achieved with relatively high efficiency by first solving $T$, i.e., by first finding an intermediate vector $z \in \mathbb{F}_2^{dp}$ which satisfies $y^{tr} = Tz^{tr}$. Then, the desired vector $x$ which satisfies $y^{tr} = H_1 x^{tr}$ is found by computing $x^{tr} = Fz^{tr}$.

As noted above, the matrices $F$ and $T$ are readily determined from the matrix $H_1$, which in turn is determined by the slopes selected to define the parity sums.

For the general case of a given value of $d$, $F$ will be a product of $d$ - 1 upper-triangular matrices of the form

$$F = \prod_{a=1}^{d-1} F^{(a)}, \tag{15}$$

where $F^{(a)} = \begin{bmatrix} F_{i,j}^{(a)} \end{bmatrix} \in M_{dp,dp}$, defined as

$$F_{i,j}^{(a)} = \begin{cases} I & \text{for } i = j \\ S^{m_a} & \text{for } j = i+1 \text{ and } j \geq a \\ 0 & \text{otherwise} \end{cases} \qquad (16)$$

For the case of general $d$, $T$ will be lower-triangular and each element in the first column of $T$ will be $I$. More formally, we have $T = [T_{i,j}] \in M_{dp,dp}(\mathbb{F}_2)$, where $T_{i,j} \in M_{p,p}(\mathbb{F}_2)$ is defined by

$$T_{i,j} = \begin{cases} I, & \text{for } i = 1 \text{ and } 1 \leq j \leq d, \\ 0, & \text{for } i < j, \\ \prod_{a=1}^{j-1}(S^{m_a} + S^{m_j}), & \text{otherwise.} \end{cases} \qquad (17)$$

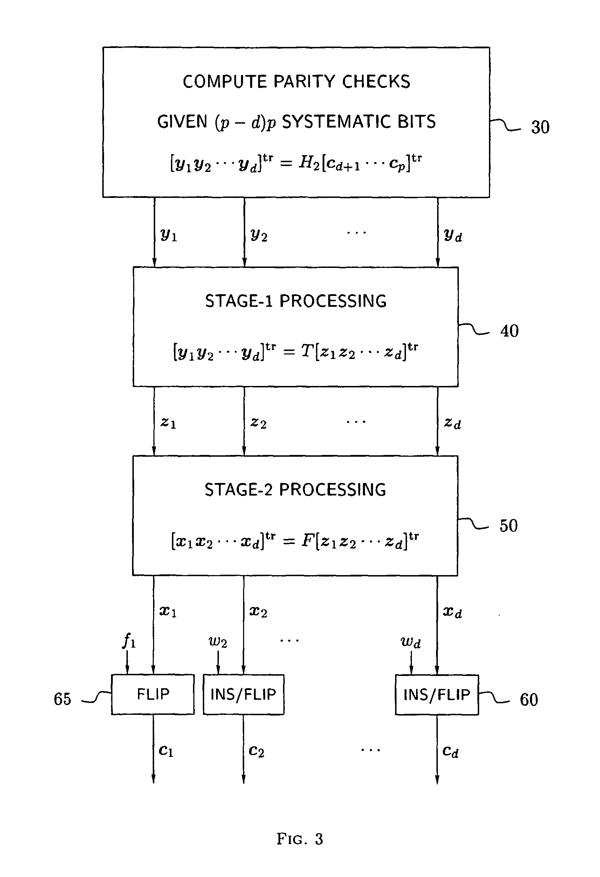

With reference to the illustrative embodiment of the invention illustrated in FIG. 3, the data word, consisting of $p(p - d) + d - 1$ systematic bits, is input to Block 30 of the figure. In Block 30, parity sums are computed over all but $d$ - 1 of the systematic bits. The output of Block 30 is vector $\boldsymbol{y} = \boldsymbol{y}_1 \cdots \boldsymbol{y}_d$, as described above. Details of actions performed in Block 30 will be provided below.

At Block 40, actions which we refer to as "Stage-1 Processing" are performed to find an intermediate vector $\boldsymbol{z} = \boldsymbol{z}_1 \boldsymbol{z}_2 \cdots \boldsymbol{z}_d$ which satisfies the matrix equation $\boldsymbol{y}^{tr} = T\boldsymbol{z}^{tr}$. Details of Stage-1 Processing will be described below.

The output of Stage-1 Processing is vector $\boldsymbol{z}$, whose respective first through $d$-th subvectors are represented as $\boldsymbol{z}_1, \boldsymbol{z}_2, \dots, \boldsymbol{z}_d$ as output of Box 40 of FIG. 3.

In Box 50, actions which we refer to as "Stage-2 Processing" are performed to compute the vector $x$ which results from the matrix multiplication $\boldsymbol{x}^{tr} = F\boldsymbol{z}^{tr}$. Details of Stage-2 Processing will be provided below.

The output of Stage-2 Processing is vector $x$, whose respective $p$-bit subvectors are represented as $\boldsymbol{x}_1, \boldsymbol{x}_2, \dots, \boldsymbol{x}_d$ at the output of Box 50 in FIG. 3.

Optionally, the first d rows of the codeword can be modified to add a further $d$ - 1 systematic bits $w_2 \cdots w_d$, otherwise $w_i = 0$, where $2 \leq i \leq d$. This procedure is illustrated by Blocks 60 of FIG. 3.

Turning to FIG. 2, it will be seen that the initial bit position 20 of the second up to the $d$-th row 10 is reserved for these $d$ - 1 systematic bits $w_2 ... w_d$. The first position in each row indicates advantageous locations for these $d$ - 1 systematic bits. That is, one systematic bit is inserted in the first column, in each of the second through d-th rows and at the same time transforming the vectors $\boldsymbol{x}_1, \boldsymbol{x}_2, \dots, \boldsymbol{x}_d$ into the first $d$ rows of the codeword $\boldsymbol{c}_1 \cdots \boldsymbol{c}_d$.

Turning back to FIG. 3, the procedure for inserting the further systematic bits will now be described. The systematic bits to be inserted are represented in the figure by $w_i$, $2 \leq i \leq d$. Each of the systematic bits $w_i$ is compared with the current bit $x_{i,1}$ at the pertinent location; i.e., with the bit it is to replace. If the insertion is equivalent to a flip of the current bit (i.e., from 0 to 1 or from 1 to 0), then the entire row must be flipped and a flip decision variable $f_i$ is set to 1, otherwise $f_i = 0$. In other words, $\boldsymbol{c}_i = \boldsymbol{x}_i + f_i$. Furthermore, if the insertion of all $d$ - 1 systematic bits causes, in total, the flipping of an odd number of rows, then the first vector $\boldsymbol{x}_0$, must also be flipped in entirety. This further flip decision, that uses $f_1 = f_2 + \cdots + f_d$ is indicated by Box 65 in the figure. The resulting vector $\boldsymbol{c}_1 = \boldsymbol{x}_i + f_1$.

The operation performed in Block 30 of FIG. 3 can be performed very efficiently if the parity check matrix $H$ adheres to the structure specified in Equation 3. We describe a vector-oriented method to compute the parity check subvectors $\boldsymbol{y}_1, \cdots \boldsymbol{y}_d$ given the subvectors $\boldsymbol{c}_{d+1}, \boldsymbol{c}_{d+2}, \dots, \boldsymbol{c}_p$ in $p - d + 1$ steps. Let a binary vector $\boldsymbol{q}_i$ of length $p$ be a temporary vector that stores intermediate results for the computation of the parity check subvector $\boldsymbol{y}_i$ that is associated with slope $m_i$. At the start of each parity-check computation for a new codeword, we initialize $\boldsymbol{q}_i$ as $\boldsymbol{q}_i = \boldsymbol{q}_i^{(0)} = 0$. Then, we update the vector $\boldsymbol{q}_i$ using the recursion relation

$$q_i^{(t)} = S^{m_i} q_i^{(t-1)} + c_{p-t+1}, \tag{18}$$

where $1 \leq t \leq p - d$. It can be verified that after $p - d$ steps we obtain

$$q_i^{(p-d)} = S^{(p-d-1)m_i} c_p + S^{(p-d-2)m_i} c_{p-1} + \cdots + S^{m_i} c_{d+2} + c_{d+1}. \tag{19}$$

In the final step, we perform an additional cyclic shift operation by $S^{dm_i}$ to obtain

$$y_i = S^{dm_i} q_i^{(p-d)} = S^{(p-1)m_i} c_p + S^{(p-2)m_i} c_{p-1} + \cdots + S^{(d+1)m_i} c_{d+2} + S^{dm_i} c_{d+1}. \tag{20}$$

This scheme can be generalized by processing multiple subvectors $c_i$ in one step. Let $g$ denote the number of subvectors that are processed in one step. Now consider the following recursion relation

$$q_i^{(gt)} = S^{gm_i} q_i^{(g(t-1))} + \sum_{j=0}^{g-1} S^{(g-j-1)m_i} c_{p-g(t-1)-j} \tag{21}$$

where $1 \leq t \leq (p - d)/g$.

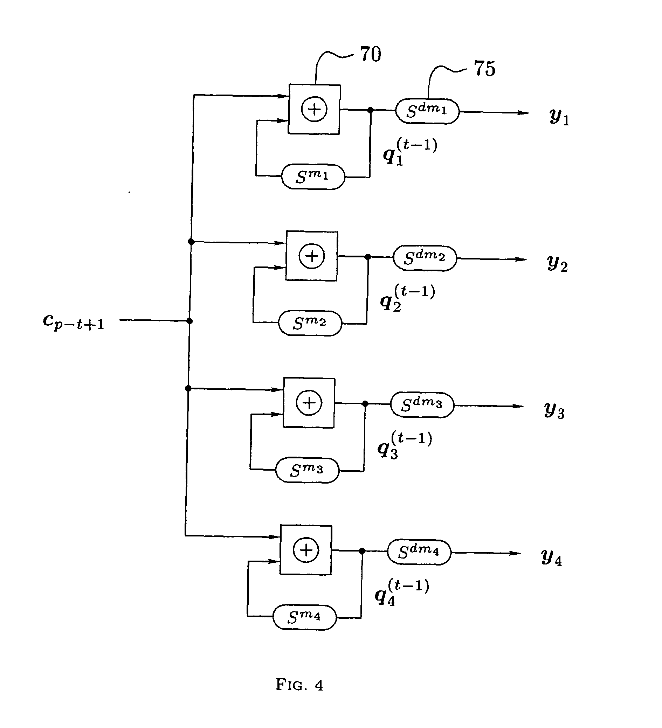

This method is illustrated in FIG. 4, where $d = 4$ and $g = 1$. It shows the details of the parity check computation module Block 30 in FIG. 3 for specific LDPC codes. Modulo-2 addition of two vectors of length p each is indicated in the figure by Boxes 70. In a hardware implementation, Box 70 is typically composed of p independent modules. Each of the p modules performs a 2-input XOR operation and contains an element to store intermediary results. The storage elements are initialized to 0 to obtain $q_i^{(0)} = 0$. An operation of cyclically shifting a vector of length p by $dm_1$ positions is dictated by a shift operator $S^{dm_1}$ as indicated in Box 75. It can be seen that by cyclically shifting the subvectors $q_i$ that store intermediary results, we obtain a very simple structure that is specifically suitable for hardware implementation.

Stage-1 processing will now be described. We continue the illustrative example of FIG. 3, in which d = 4. Accordingly, inputs to the Stage-1 Processing Block 40 of FIG. 3 consist of the binary-valued vectors $y_1$, $y_2$, $y_3$, $y_4$, which as noted above are determined by the parity sums over the systematic bits $c_{d+1} \cdots c_p$, i.e., $y^{tr} = H_2 [c_{d+1} \cdots c_p]^{tr}$. As noted, the object of Stage-1 processing is to solve T, i.e., to find a vector $z = z_1 z_2 z_3 z_4$ such that $y^{tr} = Tz^{tr}$, where $y = y_1 y_2 y_3 y_4$. As stated previously, for $d = 4$, matrix $T$ has the form

$$T = \begin{bmatrix} I & 0 & 0 & 0 \\ I & (S^{m_1} + S^{m_2}) & 0 & 0 \\ I & (S^{m_1} + S^{m_3}) & (S^{m_1} + S^{m_3})(S^{m_2} + S^{m_3}) & 0 \\ I & (S^{m_1} + S^{m_4}) & (S^{m_1} + S^{m_4})(S^{m_2} + S^{m_4}) & (S^{m_1} + S^{m_4})(S^{m_2} + S^{m_4})(S^{m_3} + S^{m_4}) \end{bmatrix}. \tag{22}$$

It follows directly that $y_1 = z_1$. By introducing the intermediary vectors $v_{i,1}^{tr} = y_1^{tr} + y_i^{tr}$,

where $1 \leq i \leq 3$, we can rewrite $y^{tr} = Tz^{tr}$ to obtain

$$\begin{bmatrix} v_{2,1}^{tr} \\ v_{3,1}^{tr} \\ v_{4,1}^{tr} \end{bmatrix} = R^{(2)} \begin{bmatrix} z_2^{tr} \\ z_3^{tr} \\ z_4^{tr} \end{bmatrix} \tag{23}$$

where $R^{(2)}$ is derived by deleting the first row and column of $T$, i.e.,

$$R^{(2)} = \begin{bmatrix} (S^{m_1} + S^{m_2}) & 0 & 0 \\ (S^{m_1} + S^{m_3}) & (S^{m_1} + S^{m_3})(S^{m_2} + S^{m_3}) & 0 \\ (S^{m_1} + S^{m_4}) & (S^{m_1} + S^{m_4})(S^{m_2} + S^{m_4}) & (S^{m_1} + S^{m_4})(S^{m_2} + S^{m_4})(S^{m_3} + S^{m_4}) \end{bmatrix} \tag{24}$$

This matrix can be written as $R^{(2)} = P^{(2)}T^{(2)}$, where

$$P^{(2)} = \begin{bmatrix} (S^{m_1} + S^{m_2}) & 0 & 0 \\ 0 & (S^{m_1} + S^{m_3}) & 0 \\ 0 & 0 & (S^{m_1} + S^{m_4}) \end{bmatrix} \tag{25}$$

and

$$T^{(2)} = \begin{bmatrix} I & 0 & 0 \\ I & (S^{m_2} + S^{m_3}) & 0 \\ I & (S^{m_2} + S^{m_4}) & (S^{m_2} + S^{m_4})(S^{m_3} + S^{m_4}) \end{bmatrix} \tag{26}$$

It should be noted that this matrix $T^{(2)}$ is of the same form as $T$. As a result, we now have two systems of equations:

$$\begin{bmatrix} v_{2,1}^{tr} \\ v_{3,1}^{tr} \\ v_{4,1}^{tr} \end{bmatrix} = \begin{bmatrix} (S^{m_1} + S^{m_2}) & 0 & 0 \\ 0 & (S^{m_1} + S^{m_3}) & 0 \\ 0 & 0 & (S^{m_1} + S^{m_4}) \end{bmatrix} \begin{bmatrix} u_{2,1}^{tr} \\ u_{3,1}^{tr} \\ u_{4,1}^{tr} \end{bmatrix} \tag{27}$$

and

$$\begin{bmatrix} u_{2,1}^{tr} \\ u_{3,1}^{tr} \\ u_{4,1}^{tr} \end{bmatrix} = \begin{bmatrix} I & 0 & 0 \\ I & (S^{m_2} + S^{m_3}) & 0 \\ I & (S^{m_2} + S^{m_4}) & (S^{m_2} + S^{m_4})(S^{m_3} + S^{m_4}) \end{bmatrix} \begin{bmatrix} z_2^{tr} \\ z_3^{tr} \\ z_4^{tr} \end{bmatrix} . \tag{28}$$

The intermediary vectors $u_{2,1}$, $u_{3,1}$ and $u_{4,1}$ can be solved as described below. The original set of equations $y^{tr} = Tz^{tr}$ has now been reduced in one step from a system of $dp$ equations to a system of $(d-1)p$ equations, where the matrix $T^{(2)}$ resulting in the system $[u_{2,1}u_{3,1}u_{4,1}]^{tr} = T^{(2)} [z_2z_3z_4]^{tr}$ has the same form as $T$. It follows that we can proceed recursively to obtain the complete solution to $y^{tr} = Tz^{tr}$ in $d — 1$ steps.

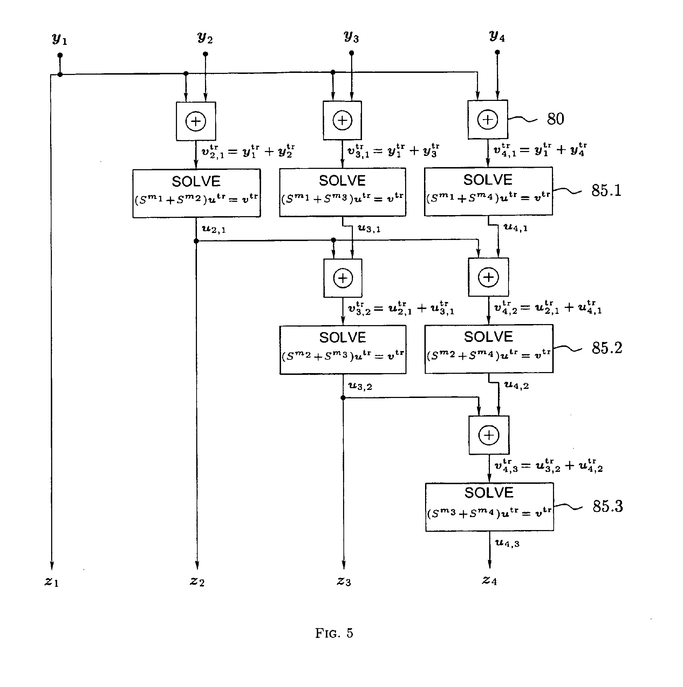

We turn now to FIG. 5. As will be explained below, Stage-1 processing is carried out by several sequences of basic operations, some of which can be performed in parallel. These operations are of two kinds. Modulo-2 addition of two vectors of length $p$ each is indicated in the figure by Boxes 80. Solving with respect to an operator is indicated by Boxes 85.1, 85.2, and 85.3.

The relationship among the vectors $z = z_1z_2z_3z_4$ and $y = y_1y_2y_3y_4$ and the intermediary vectors $u_{i,j}$ and $v_{i,j}$ may become more clear by following the reverse flow from z to $y$. It can be verified that the reverse flow consists of a combination of shift operations and vector-wise modulo-2 additions. The operation $(S^{m_a} + S^{m_b})u^{tr} = v^{tr}$ reduces in the reverse direction to the addition of two cyclically shifted copies (by $m_a$ and $m_b$) of a vector $u$. In the reverse direction, it is easy to verify that the matrix $T$ is formed in d - 1 steps.

We return to FIG. 5 and consider the flow of operation as indicated in the figure. The set of equations specified by $y^{tr} = Tz^{tr}$ is solved in $d$ - 1 steps. In each Box 80, we perform parallel exclusive-or (XOR) operations to form the sums

$$v_{i,1}^{tr} = y_1^{tr} + y_i^{tr}, \text{ for } 2 \le i \le d. \quad \text{for } 2 \le i \le d.$$

In the six boxes labelled as Box 85.1, Box 85.2 and Box 85.3, an expression of the form $(S^{m_a} + s^{m_b})u^{tr} = v^{tr}$ is solved for given values $v$, $m_a$ and $m_b$, in which $v$ is the pertinent intermediary variable. It will be seen from FIG. 5 that each solution in Boxes 85.1 produces an intermediary variable $u_{i,1}$. The variable $u_{2,1}$ is output as $z_2$ and passed forward to be summed with, repectively, $u_{3,1}$ and $u_{4,1}$. The resulting sums are passed forward to Boxes 85.2. The solutions in Boxes 85.2 produce, respectively, the intermediary variables $u_{3,2}$ and $u_{4,2}$. The variable $u_{3,2}$ is output as $z_3$. The variable $u_{4,2}$ is summed with $u_{3,2}$ and passed forward to Box 85.3. The output of Box 85.3 is $u_{4,3}$, which is output as $z_4$.

One method of solution to be carried out in Boxes 85.1-85.3 is to construct the matrix inverse of each of the operators $S^{m_a} + S^{m_b}$, and apply it to the appropriate variable $v^{tr}$ by left-multiplication. A second approach employs an algorithm which we here denominate SOLVER. SOLVER takes advantage of the cyclic properties of the shift operators and the cyclic properties of modulo-2 arithmetic to achieve significant improvements in computational efficiency over approaches based on straightforward matrix multiplication. SOLVER will be described below.

Those skilled in the art will appreciate that because of the triangular form of matrix T, it is straightforward to extend the procedure described above to any value of $d$.

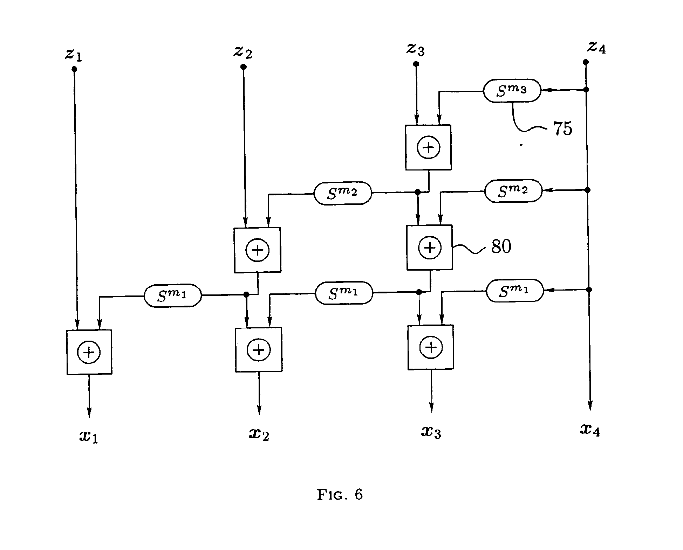

As noted, the object of Stage-2 processing is to compute the vector $x$ which results from the matrix multiplication $x^{tr} = Fz^{tr}$. Stage-2 processing will be described with reference to FIG. 6.

As seen in the figure, the matrix multiplication is carried out by several sequences of basic operations, some of which can be carried out in parallel. The operations are of two kinds. As in the previous figure, modulo-2 addition is represented by Box 80. An operation of cyclically shifting a vector of length $p$ by $a$ positions is dictated by a shift operator $S^a$ as indicated in Box 75.

As seen in the figure, the input value for $z_4$ is passed directly to output as $x_4$. To construct $x_3$, we cyclically shift $z_4$ by $m_2$ positions and add the result to $z_3$. The vectors $x_2$ and $x_1$ are constructed recursively in a similar fashion.

Those skilled in the art will appreciate that due to the special factorization of $F$ described above, it is straightforward to extend the procedure of FIG. 6 to any value of $d$.

As noted above, an algorithm we refer to as SOLVER can efficiently solve expressions of the form $(S^a + S^b)$ $u^{tr} = v^{tr}$; that is, given $v$ and $a$, $b \in \mathbb{Z}_p$, SOLVER will effectively invert $(S^a + S^b)$ so as to obtain a value for u. SOLVER is defined by the following statements, in which it will be understood that all arithmetic is modulo-2.

The expression $(S^a + S^b)u^{tr} = v^{tr}$, where $a, b \in \mathbb{Z}_p$, $u = u_0u_1 \cdots u_{p-1}$ and $v = v_0v_1 \cdots v_{p-1}$, specifies a set of $p$ equations of the form $u_{i+a} + u_{i+b} = v_i$, where $i \in \mathbb{Z}_p$. Notice that here and in the following, all indices of $u$ and $v$ are assumed to be modulo $p$. By substituting $i = j(a - b)$, we obtain

$$u_{j(a-b)+a} + u_{j(a-b)+b} = v_{j(a-b)} \tag{29}$$

which is equivalent to

$$u_{j(a-b)+a} + u_{(j-1)(a-b)+a} = v_{j(a-b)} \tag{30}$$

To simplify the variable indices in this expression and to eliminate the dependence on parameters $a$ and $b$, we introduce the binary vectors $\boldsymbol{t} = t_0 t_1 \cdots t_{p-1}$ and $\boldsymbol{r} = r_0 r_1 \cdots r_{p-1}$, defined by

$$t_i = v_{(i+1)(a-b)} \tag{31}$$

and

$$r_i = u_{i(a-b)+a} \tag{32}$$

We now can rewrite Equation (29) to

$$r_i + r_{i-1} = t_{i-1} \tag{33}$$

or, equivalently

$$t_i = r_i + r_{i+1} \tag{34}$$

Notice that as a result of these substitutions one obtains a set of equations that is independent of $a$ and $b$.

Equivalently, the effect of the substitution of the variables can be specified by $\boldsymbol{t}^{\mathrm{tr}} = \Pi^{(1;a,b)}\boldsymbol{v}^{\mathrm{tr}}$, where $\Pi^{(1;a,b)}$ denotes a permutation matrix $\Pi^{(1;a,b)} = [\pi^{(1)}_{i+1,j+1}] \in \mathcal{M}_{p,p}(\mathbb{F}_2)$, where $i, j \in \mathbb{Z}_p$, specified by

$$\pi^{(1)}_{i+1,j+1} = \begin{cases} 1, & \text{if } j = (i+1)(a-b) \bmod p, \\ 0, & \text{otherwise.} \end{cases} \tag{35}$$

Similarly, $\boldsymbol{r}^{\mathrm{tr}} = \Pi^{(2;a,b)}\boldsymbol{u}^{\mathrm{tr}}$, where $\Pi^{(2;a,b)}$ denotes a permutation matrix $\Pi^{(2;a,b)} = [\pi^{(2)}_{i+1,j+1}] \in \mathcal{M}_{p,p}(\mathbb{F}_2)$, where $i, j \in \mathbb{Z}_p$, specified by

$$\pi^{(2)}_{i+1,j+1} = \begin{cases} 1, & \text{if } j = (i(a-b)+a) \bmod p, \\ 0, & \text{otherwise.} \end{cases} \tag{36}$$

Notice that, as before, the rows and columns of the permutation matrices $\Pi^{(1;a,b)}$ and $\Pi^{(2;a,b)}$ are numbered from 1 to $p$. However, the indices of the vectors $\boldsymbol{u}$ and $\boldsymbol{v}$ are numbered from 0 to $p - 1$ as stated previously, and this is the case for vectors $\boldsymbol{r}$ and $\boldsymbol{t}$ also.

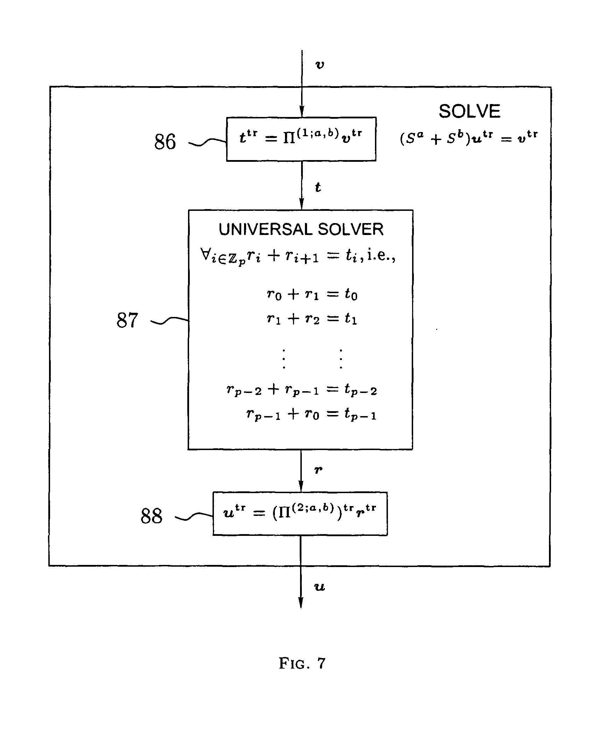

FIG. 7 shows a high-level flow chart of SOLVER, the module that solves the set of equations specified by (S$^a$

+ $S^b)u^{tr} = v^{tr}$. In Block 86, the input vector $v$ is permuted by permutation matrix $\Pi^{(1;a,b)}$ to obtain $t^{tr} = \Pi^{(1;a,b)}v^{tr}$. Notice that this operation constitutes a permutation of elements of $v$ and that it does not involve any logic computations. Block 87 represents a universal SOLVER module that takes a vector $t$, solves the set of $p$ equations of the form $r_i + r_{i+1} = t_i$, for all $i \in \mathbb{Z}_{p}$, and outputs the solution vector $r$. Details of this procedure will be described in the next paragraphs. Block 88 performs the permutation $u^{tr} = \Pi^{(2;a,b)tr}r^{tr}$ to obtain the solution vector $u$ to $(S^a + S^b)u^{tr} = v^{tr}$. Notice that the permutation matrix $\Pi^{(2;a,b)tr}$ is the inverse of the permutation matrix $\Pi^{(2;a,b)}$.

The objective is to solve $r = \Pi^{(2;a,b)}u$ for a given $t^{tr} = \Pi^{(1;a,b)}v^{tr}$. The parity of the solution vector $u$ equals the parity of the permuted vector $r$, and is given by

$$\sum_{i=0}^{p-1} r_i = r_0 + \sum_{i=1}^{(p-1)/2} t_{2i-1} \tag{37}$$

To solve the overall set of equations specified by $y^{tr} = H_1 x^{tr}$, all invocations of SOLVER in Block 40 of FIG. 3 are required to have solutions of the same parity. In the following, we require by convention that all the solutions have even parity. It follows directly that

$$r_0 = \sum_{i=1}^{(p-1)/2} t_{2i-1}. \tag{38}$$

Let

$$\sigma(t, \ell, i, m) = t_\ell + t_{\ell+i} + t_{\ell+2i} + \cdots + t_m, \tag{39}$$

where $(m-\ell)$ is a multiple of $i$. The depth $\delta(\sigma(t, \ell, i, m))$ is defined as the maximum number of logical 2-input XOR operations between the function output $t_{\ell;i;m} = \sigma(t, \ell, i, m)$ and any of its inputs. It can be verified that the function $\sigma(t, \ell, i, m)$ requires

$$\chi(\sigma(t, \ell, i, m)) = (m - \ell)/i \tag{40}$$

XOR operations and can be realized with depth

$$\delta(\sigma(t, \ell, i, m)) = \lceil \log_2(\chi(\sigma(t, \ell, i, m))) \rceil. \tag{41}$$

Using this notation, Equation (38) is reduced to

$$r_0 = t_{1;2;p-2} = \sigma(t, 1, 2, p - 2). \tag{42}$$

This equation can be computed using $(p - 3)/2$ XOR operations and can be realized with depth $\lceil \log_2(p- 1) - 1 \rceil$.

As soon as the value $r_0$ has been determined, the values $r_1, r_2, \cdots, r_q$, where $q = (n - 1)/2$, can be computed recursively using $r_i = r_{i-1} + t_{i-1}$ for $1 \le i \le q$. This requires q XOR operations and the maximum depth is $q$. Similarly, the values $r_{p-1}, r_{p-2}, \cdots, r_{q+1}$ can be computed recursively starting with $r_{p-1} = r_0 + t_{p-1}$, followed by $r_{p-i} = r_{p-i+1} + t_{p-i}$ for $2 \le i \le q$. In this scenario, the resulting computation of $r$ given $t$ and $r_0$ requires 2q XOR operations and has a minimum depth of $q$.

In a hardware implementation, the number of computations that can be performed within one clock cycle depends on the depth. To reduce the depth of the computation of r given t, one can employ one of the following techniques.

In one embodiment of SOLVER, we exploit the following two observations to solve $(S^a + S^b)\boldsymbol{u}^{tr} = \boldsymbol{v}^{tr}$ with permutations $\boldsymbol{t}^{tr} = \Pi^{(1;a,b)}\boldsymbol{v}^{tr}$ and $\boldsymbol{r}^{tr} = \Pi^{(2;a,b)}\boldsymbol{u}^{tr}$.

$$r_\ell = \sigma(\boldsymbol{t}, 0, 1, \ell - 1) + r_0, \qquad (43)$$

$$r_{p-\ell} = \sigma(\boldsymbol{t}, p - \ell, 1, p - 1) + r_0 \qquad (44)$$

It follows from Equation (41) that $r_\ell$ can be computed with depth

$$\delta(\sigma(\boldsymbol{t}, 0, 1, \ell - 1) + r_0) = \max(\lceil \log_2(\chi(\sigma(\boldsymbol{t}, 0, 1, \ell - 1)))\rceil, \lceil \log_2(\chi(\sigma(\boldsymbol{t}, 1, 2, p - 2)))\rceil) + 1.$$

This implies that for any $1 \le \ell \le q$, we can compute the value of $r_\ell$ with circuitry that has a depth $\lceil \log_2(p - 1)\rceil$. By carefully selecting the groupings of XOR operations one can reuse most of the intermediary sum-terms for the calculation of $r_0 = \sigma(\boldsymbol{t}, 1, 2, p - 2)$ and each of o the $2q$ terms specified by Equation (43) and Equation (44).

In an alternative embodiment of SOLVER, one precomputes $\lceil 2q/\vartheta\rceil$ instead of $2q$ intermediary sum-terms. In the following, we first consider the computation of the values $r_1 \cdots r_q$. Let $t_{0;1;j\vartheta-1} = \sigma(\boldsymbol{t}, 0, 1, j\vartheta - 1)$, where $1 \le j \le \lceil q/\vartheta\rceil$. In particular, by choosing $\vartheta = 2^\eta$, we can efficiently combine intermediary sum-terms for the computation of $r_0 = \sigma(\boldsymbol{t}, 1, 2, p - 2)$ and $t_{0,1;j\vartheta-1} = \sigma(\boldsymbol{t}, 0, 1, j\vartheta - 1)$. The values $r_\vartheta = t_{0;1;j\vartheta-1} + r_0$ can be computed with a circuitry with depth $\lceil \log_2(p - 1)\rceil$.

This implementation has the advantage that a large number of intermediary sum-terms can be reused for the computation of $r_0$ and $t_{0;1;j\vartheta-1}$. For the computation of $r_0$, we construct sum-terms of the form $t_{i;2;i+2} = t_i + t_{i+2}$ for $i = 1, 5, \ldots, i_{max}$, and $i_{max} = 2\lceil Q/2\rceil - 3$. Each of the intermediary values $t_{i;2;i+2}$ has depth 1. In a similar fashion, we can now recursively compute the following intermediary variables $t_{i \cdot 2^e+1_{+1;2;(i+1)2}e+1_{-1}}$, for increasing values of e, where $2 \le e \le \lfloor q - 1\rfloor - 1$. We now have

$$t_{i \cdot 2^{e+1}+1;2;(i+1)2^{e+1}-1} = t_{i \cdot 2^{e+1}+1;2;i \cdot 2^{e+1}+2^e-1} + t_{i \cdot 2^{e+1}+2^e+1;2;(i+1)2^{e+1}-1} \qquad (45)$$

for $0 \le i \le i_{max}$, where $i_{max} = \lfloor (q - 2^{e+1} - 1)/2^{e+1}\rfloor$. We can sum the variables $t_i$, where $i$ is even, in a similar fashion. We then obtain

$$t_{0;1;j\vartheta-1} = t_{1;2;j\vartheta-1} + t_{0;2;j\vartheta-2} \qquad (46)$$

The terms in the neighborhood of $r_{j\vartheta}$ can now be computed recursively using

$$r_{j\vartheta+\ell} = \sigma(\boldsymbol{t}, j\vartheta, 1, j\vartheta + \ell - 1) + r_{j\vartheta} + r_0, \qquad (47)$$

$$r_{j\vartheta-\ell} = \sigma(\boldsymbol{t}, j\vartheta - \ell, 1, j\vartheta - 1) + r_{j\vartheta} + r_0 \qquad (48)$$

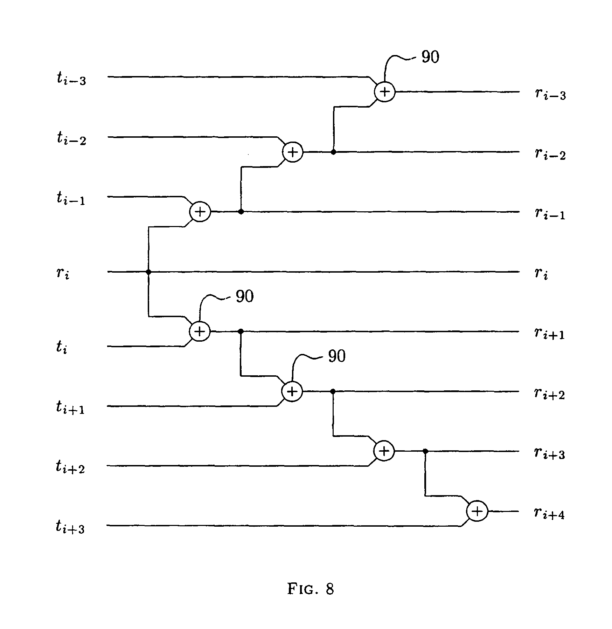

A possible implementation of such a circuit is given in FIG. 8, where $r_{j\vartheta}$ corresponds to $r_i$, and $\eta = 3$. Elements 90 of FIG. 8 are, e.g., logical gates for performing a 2-input XOR operation.

It follows that by precomputing $t_{0;1;j\vartheta-1} = \sigma(\boldsymbol{t}, 0, 1, j\vartheta - 1)$ we can compute $\vartheta - 1$ neighboring values with only $\vartheta - 1$ XOR operations and a maximum depth of $2^\eta - 1$ when the value $r_{j\vartheta} = t_{0;1;j\vartheta-1} + r_0$ is known.

The values of $r_{q+1} \cdots r_{p-1}$ can be determined in a similar fashion by exploiting the symmetry in computation.

The depth of the computation of $r$ given $t$ is now somewhere between $\lceil \log_2(p-1)-1 \rceil + 2$ and $\lceil \log_2(p-1)-1 \rceil + 2^{\eta-1}+1$.

There are numerous other implementations that trade-off depth against the number of XOR operations.

Notice that the invention is not limited to codes that adhere to the specific structure of the illustrative example. The processing blocks specified in FIG. 3 are much more general. The details of the parity-check computation block 30 in FIG. 4 are specific to code structures specified by Equation 3. However, the details of the Stage-I Processing block illustrated in FIG. 5 and the Stage-II processing block illustrated in FIG. 6 do not require the submatrix $H_2$ to satisfy any particular requirement.

## Claims

1. A method for computing a codeword that includes systematic bits and check bits, in which the check bits are required to satisfy linear constraints of a form in which specified groups of check bits must add up to respective parity sums, the method comprising:

   computing (30) the parity sums from the systematic bits;
   solving (40, 50) a constraint equation to obtain the values for the check bits; and
   appending the check bits to the systematic bits;
   **CHARACTERISED IN THAT** solving the constraint equation comprises:
   arranging the parity sums into vectors $y_i$, $1 \leq i \leq d$, wherein $d$ is the number of linear constraints imposed on each check bit;
   computing (40) an intermediate set of vectors $z_i$ from the vectors $y_i$ using a recursive relationship among the vectors $z_i$; and
   computing (50) the values for the check bits as a set of vectors $x_i$ by a circuit having multiple levels, in which at least one subcircuit at each level obtains two vector inputs, sums (80) one of the vector inputs with a shifted (75) version of the other vector input, and passes the result to the next level or outputs it as one of the vectors $x_i$.

2. The method of Claim 1, wherein the operations (80, 85.1, 85.2, 85.3) for computing the vectors $z_i$ are effective for solving a matrix equation of the form $y^{tr} = Tz^{tr}$, wherein $y = y_1...y_d$ is a vector, $z = z_1...z_d$ is a vector, and $T$ is a lower-triangular matrix of submatrices that correspond to cyclic shift operations or to sums and products of cyclic shift operations.

3. The method of Claim 1, wherein the operations (75, 80) for computing the subvectors $x_i$ are effective for performing a matrix multiplication of the form $x^{tr} = Fz^{tr}$, wherein $x = x_1...x_d$ is a vector, $z = z_1...z_d$ is a vector, and $F$ is a product of upper triangular matrices of submatrices that correspond to cyclic shift operations.

4. The method of Claim 1, wherein the operations (75, 80) for computing the vectors $z_i$ comprise computing (85.1, 85.2, 85.3) pre-images of binary-valued quantities under operators of the form $(S^a + S^b)$, in which $S^a$ and $S^b$ are cyclic shift operators.

5. The method of Claim 4, wherein at least some of said pre-images are computed using a recursive sequence of XOR operations (80) to obtain the pre-images in permuted form.

6. The method of Claim 1, wherein: at least some of the systematic bits are arranged into $p - d$ vectors (10) denominated $c_{d+1}, c_{d+2}, ..., c_p$; and each of the vectors $y_i$ of parity sums is computed in $p - d$ updates (70) of a vector $q_i$, followed by a cyclic shift (75) of $q_i$.

7. The method of Claim 6, wherein: $S^{m_i}$ is a cyclic shift operator; $q_i$ is initialized to an all-zero vector denominated $q_i^{(0)}$; each of the $p - d$ updates has the form $q_i^{(t)} = S^{m_i} q_i^{(t-1)}$ for $t = 1,..., p - d$; and the updates are followed by a cyclic shift of the form $y_i = S^{dm_i} q_i^{(p-d)}$.

8. The method of Claim 1, further comprising, after obtaining the values for the check bits, inserting (60) at least one further systematic bit but not more than $d$-1 such further bits in place of respective check bits.

9. The method of Claim 8, further comprising updating (60) the values of the check bits in response to the insertion of said one or more further systematic bits.

**Patentansprüche**

1.  Verfahren zum Berechnen eines Codeworts, das systematische Bit und Prüfbit enthält, bei dem die Prüfbit benötigt werden, um lineare Nebenbedingungen einer Form zu erfüllen, bei der sich spezifizierte Gruppen von Prüfbit zu jeweiligen Paritätssummen aufaddieren müssen, wobei das Verfahren die folgenden Schritte umfaßt:

    Berechnen (30) der Paritätssummen aus den systematischen Bit;
    Lösen (40, 50) einer Nebenbedingungsgleichung, um die Werte für die Prüfbit zu erhalten; und
    Anhängen der Prüfbit an die systematischen Bit;
    **dadurch gekennzeichnet, daß** das Lösen der Nebenbedingungsgleichung folgendes umfaßt:
    Anordnen der Paritätssummen zu Vektoren $\boldsymbol{y}_i$, $1 \leq i \leq d$, wobei $d$ die Anzahl der jedem Prüfbit auferlegten linearen Nebenbedingungen ist;
    Berechnen (40) einer Zwischenmenge von Vektoren $\boldsymbol{z}_i$ aus den Vektoren $\boldsymbol{y}_i$ unter Verwendung einer rekursiven Beziehung zwischen den Vektoren $\boldsymbol{z}_i$; und
    Berechnen (50) der Werte für die Prüfbit als eine Menge von Vektoren $\boldsymbol{x}_i$ durch eine Schaltung mit mehreren Ebenen, bei der mindestens eine Teilschaltung auf jeder Ebene zwei Vektoreingaben erhält, eine der Vektoreingaben mit einer verschobenen (75) Version der anderen Vektoreingabe summiert (80) und das Ergebnis zu der nächsten Ebene weiterleitet oder es als einen der Vektoren $\boldsymbol{x}_i$ ausgibt.

2.  Verfahren nach Anspruch 1, wobei die Operationen (80, 85.1, 85.2, 85.3) zur Berechnung der Vektoren $\boldsymbol{z}_i$ zum Lösen einer Matrixgleichung der Form $\boldsymbol{y}^{tr} = \boldsymbol{T}\boldsymbol{z}^{tr}$ effektiv sind, wobei $\boldsymbol{y} = \boldsymbol{y}_1 \dots \boldsymbol{y}_d$ ein Vektor ist, $\boldsymbol{z} = \boldsymbol{z}_1 \dots \boldsymbol{z}_d$ ein Vektor ist und $\boldsymbol{T}$ eine Dreiecksmatrix von Teilmatrizen ist, die zyklischen Verschiebeoperationen oder Summen und Produkten von zyklischen Verschiebeoperationen entsprechen.

3.  Verfahren nach Anspruch 1, wobei die Operationen (75, 80) zur Berechnung der Teilvektoren $\boldsymbol{x}_i$ zum Durchführen einer Matrixmultiplikation der Form $\boldsymbol{x}^{tr} = \boldsymbol{F}\boldsymbol{z}^{tr}$ effektiv sind, wobei $\boldsymbol{x} = \boldsymbol{x}_1 \dots \boldsymbol{x}_d$ ein Vektor ist, $\boldsymbol{z} = \boldsymbol{z}_1 \dots \boldsymbol{z}_d$ ein Vektor ist und $\boldsymbol{F}$ ein Produkt von oberen Dreiecksmatrizen von Teilmatrizen ist, die zyklischen Verschiebeoperationen entsprechen.

4.  Verfahren nach Anspruch 1, wobei die Operationen (75, 80) zur Berechnung der Vektoren $\boldsymbol{z}_i$ das Berechnen (85.1, 85.2, 85.3) von Urbildern von binärwertigen Größen unter Operatoren der Form $(S^a + S^b)$ umfassen, bei dem $S^a$ und $S^b$ zyklische Verschiebeoperatoren sind.

5.  Verfahren nach Anspruch 4, wobei mindestens ein Teil der Urbilder unter Verwendung einer rekursiven Sequenz von XOR-Operationen (80) berechnet wird, um die Urbilder in permutierter Form zu erhalten.

6.  Verfahren nach Anspruch 1, wobei mindestens ein Teil der systematischen Bit zu $p - d$ Vektoren (10) mit der Bezeichnung $\boldsymbol{c}_{d+1}, \boldsymbol{c}_{d+2}, \dots, \boldsymbol{c}_p$ angeordnet wird; und jeder der Vektoren $\boldsymbol{y}_i$ von Paritätssummen in $p - d$ Aktualisierungen (70) eines Vektors $\boldsymbol{q}_i$, gefolgt durch eine zyklische Verschiebung (75) von $\boldsymbol{q}_i$, berechnet wird.

7.  Verfahren nach Anspruch 6, wobei $S^{m_i}$ ein zyklischer Verschiebeoperator ist; $\boldsymbol{q}_i$ auf einen mit $\boldsymbol{q}_i^{(0)}$ bezeichneten Alle-null-Vektor initialisiert wird; jede der $p - d$ Aktualisierungen die Form $\boldsymbol{q}_i^{(t)} = S^{m_i} \boldsymbol{q}_i^{(t-1)}$ für $t = 1, \dots, p - d$ hat; und den Aktualisierungen eine zyklische Verschiebung der Form $\boldsymbol{Y}_i = S^{dm_i} \boldsymbol{q}_i^{(p-d)}$ folgt.

8.  Verfahren nach Anspruch 1, das ferner nach dem Erhalten der Werte für die Prüfbit den Schritt des Einfügens (60) mindestens eines weiteres systematisches Bit, aber nicht mehr als $d - 1$ solche weitere Bit, anstelle jeweiliger Prüfbit umfaßt.

9.  Verfahren nach Anspruch 8, ferner mit dem Schritt des Aktualisierens (60) der Werte der Prüfbit als Reaktion auf die Einfügung des einen oder der mehreren weiteren systematischen Bit.

**Revendications**

1. Procédé de calcul d'un mot de code qui comporte des bits systématiques et des bits de vérification, dans lequel les bits de vérification sont nécessaires pour satisfaire des contraintes linéaires d'une forme dans laquelle des groupes spécifiés de bits de vérification doivent se monter à des sommes de parité respectives, le procédé comprenant :

   le calcul (30) des sommes de parité à partir des bits systématiques ;
   la résolution (40, 50) d'une équation de contrainte afin d'obtenir les valeurs des bits de vérification ; et
   l'adjonction des bits de vérifications aux bits systématiques ;
   **CARACTERISE EN CE QUE** la résolution de l'équation de contrainte comprend :
   l'agencement des sommes de parité en vecteurs, $y_i$, $1 \leq i \leq d$, où $d$ est le nombre de contraintes linéaires imposées à chaque bit de vérification ;
   le calcul (40) d'un ensemble intermédiaire de vecteurs $z_i$, à partir des vecteurs $y_i$ en utilisant une relation récursive parmi les vecteurs $z_i$ ; et
   le calcul (50) des valeurs des bits de vérification sous forme d'ensemble de vecteurs $x_i$ par un circuit ayant de multiples niveaux, dans lequel au moins un sous-circuit à chaque niveau obtient deux entrées vectorielles, ajoute (80) l'une des entrées vectorielles à une version décalée (75) de l'autre entrée vectorielle, et passe le résultat au niveau suivant ou le sort comme l'un des vecteurs $x_i$.

2. Procédé selon la revendication 1, dans lequel les opérations (80, 85.1, 85.2, 85.3) pour calculer les vecteurs $z_i$ sont efficaces pour résoudre une équation matricielle de la forme $y^{tr} = Tz^{tr}$, où $y = y_1 \dots Y_d$ est un vecteur, $z = z_1 \dots z_d$ est un vecteur, et $T$ est une matrice triangulaire inférieure de sous-matrices qui correspondent à des opérations de décalage cyclique ou à des sommes et produits d'opérations de décalage cyclique.

3. Procédé selon la revendication 1, dans lequel les opérations (75, 80) pour calculer les sous-vecteurs $x_i$ sont efficaces pour effectuer une multiplication matricielle de la forme $x^{tr} = Fz^{tr}$, où $x = x_1 \dots x_d$ est un vecteur, $z = z_1 \dots z_d$ est un vecteur, et $F$ est un produit de matrices triangulaires supérieures de sous-matrices qui correspondent à des opérations de décalage cyclique.

4. Procédé selon la revendication 1, dans lequel les opérations (75, 80) pour calculer les vecteurs $z_i$ comprennent le calcul (85.1, 85.2, 85.3) de pré-images de quantités de valeurs binaires sous des opérateurs de la forme $(S^a + S^b)$, dans lequel $S^a$ et $S^b$ sont des opérateurs de décalage cyclique.

5. Procédé selon la revendication 4, dans lequel au moins certaines desdites pré-images sont calculées en utilisant une séquence récursive d'opérations OU EXCLUSIF (80) afin d'obtenir les pré-images dans une forme permutée.

6. Procédé selon la revendication 1, dans lequel au moins certains des bits systématiques sont agencés en $p - d$ vecteurs (10) dénommés $c_{d+1}$, $c_{d+2}$, ..., $c_p$ ; et chacun des vecteurs $y_i$ de sommes de parité est calculé dans $p - d$ mises à jour (70) d'un vecteur $q_i$, suivi d'un décalage cyclique (75) de $q_i$.

7. Procédé selon la revendication 6, dans lequel $S^{m_i}$ est un opérateur de décalage cyclique, $q_i$ est initialisé à un vecteur entièrement de zéros dénommé $q_i^{(0)}$, chacune des $p - d$ mises à jour a la forme $q_i^{(t)} = S^{m_i} q_i^{(t-1)}$ pour $t = 1, ..., p - d$ ; et les mises à jour sont suivies d'un décalage cyclique de la forme $y_i = S^{dm_i} q_i^{(p-d)}$.

8. Procédé selon la revendication 1, comprenant en outre, après l'obtention des valeurs des bits de vérification, l'insertion (60) d'au moins un autre bit systématique mais de pas plus de $d - 1$ tels autres bits à la place de bits de vérification respectifs.

9. Procédé selon la revendication 8, comprenant en outre la mise à jour (60) des valeurs des bits de vérification en réponse à l'insertion desdits un ou plusieurs autres bits systématiques.

FIG. 1

PRIOR ART

FIG. 2

COMPUTE PARITY CHECKS

GIVEN $(p-d)p$ SYSTEMATIC BITS

$$[y_1 y_2 \cdots y_d]^{\text{tr}} = H_2 [c_{d+1} \cdots c_p]^{\text{tr}}$$

30

$y_1$     $y_2$     $\cdots$     $y_d$

STAGE-1 PROCESSING

$$[y_1 y_2 \cdots y_d]^{\text{tr}} = T [z_1 z_2 \cdots z_d]^{\text{tr}}$$

40

$z_1$     $z_2$     $\cdots$     $z_d$

STAGE-2 PROCESSING

$$[x_1 x_2 \cdots x_d]^{\text{tr}} = F [z_1 z_2 \cdots z_d]^{\text{tr}}$$

50

$x_1$     $x_2$     $\cdots$     $x_d$

$f_1$     $w_2$     $\cdots$     $w_d$

65   FLIP     INS/FLIP     INS/FLIP   60

$c_1$     $c_2$     $\cdots$     $c_d$

FIG. 3

FIG. 4

$y_1$   $y_2$   $y_3$   $y_4$

$\bigoplus$   $\bigoplus$   $\bigoplus$   $\sim 80$

$v_{2,1}^{tr} = y_1^{tr} + y_2^{tr}$   $v_{3,1}^{tr} = y_1^{tr} + y_3^{tr}$   $v_{4,1}^{tr} = y_1^{tr} + y_4^{tr}$

SOLVE
$(S^{m_1} + S^{m_2})u^{tr} = v^{tr}$

SOLVE
$(S^{m_1} + S^{m_3})u^{tr} = v^{tr}$

SOLVE
$(S^{m_1} + S^{m_4})u^{tr} = v^{tr}$   $\sim 85.1$

$u_{2,1}$   $u_{3,1}$   $u_{4,1}$

$\bigoplus$   $\bigoplus$

$v_{3,2}^{tr} = u_{2,1}^{tr} + u_{3,1}^{tr}$   $v_{4,2}^{tr} = u_{2,1}^{tr} + u_{4,1}^{tr}$

SOLVE
$(S^{m_2} + S^{m_3})u^{tr} = v^{tr}$

SOLVE
$(S^{m_2} + S^{m_4})u^{tr} = v^{tr}$   $\sim 85.2$

$u_{3,2}$   $u_{4,2}$

$\bigoplus$

$v_{4,3}^{tr} = u_{3,2}^{tr} + u_{4,2}^{tr}$

SOLVE
$(S^{m_3} + S^{m_4})u^{tr} = v^{tr}$   $\sim 85.3$

$u_{4,3}$

$z_1$   $z_2$   $z_3$   $z_4$

Fig. 5

FIG. 6

$$v$$

SOLVE

$$86 \quad t^{\mathrm{tr}} = \Pi^{(1;a,b)} v^{\mathrm{tr}}$$

$$(S^a + S^b) u^{\mathrm{tr}} = v^{\mathrm{tr}}$$

$$t$$

UNIVERSAL SOLVER

$$\forall_{i \in \mathbb{Z}_p} r_i + r_{i+1} = t_i, \mathrm{i.e.,}$$

$$r_0 + r_1 = t_0$$
$$r_1 + r_2 = t_1$$

$$\vdots \qquad \vdots$$

$$r_{p-2} + r_{p-1} = t_{p-2}$$
$$r_{p-1} + r_0 = t_{p-1}$$

$$87$$

$$r$$

$$88 \quad u^{\mathrm{tr}} = (\Pi^{(2;a,b)})^{\mathrm{tr}} r^{\mathrm{tr}}$$

$$u$$

FIG. 7

FIG. 8

**EP 1 693 968 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YU YI et al.** The semi-algebra low-density parity-check codes. *Proc., IEEE Int. Conf. on Comm.,* 20 June 2004, 440-442